(19)

Europäisches Patentamt

European Patent Office

Office européen des brevets

(11) **EP 4 738 048 A1**

(12) **DEMANDE DE BREVET EUROPEEN**

(43) Date de publication:
06.05.2026 Bulletin 2026/19

(21) Numéro de dépôt: 25210122.5

(22) Date de dépôt: **21.10.2025**

(51) Classification Internationale des Brevets (IPC):
**G06F 1/12** (2006.01)     **H03K 5/04** (2006.01)

(52) Classification Coopérative des Brevets (CPC):
**G06F 1/12;** H03K 5/04

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **04.11.2024 FR 2412052**

(71) Demandeur: **STMicroelectronics International N.V.**
**1228 Plan-les-Ouates, Geneva (CH)**

(72) Inventeurs:
• **LACAN, Jérôme**
  **13530 TRETS (FR)**
• **EVA, Christophe**
  **13790 ROUSSET (FR)**

(74) Mandataire: **Casalonga**
**Casalonga & Partners**
**Bayerstraße 71/73**
**80335 München (DE)**

(54) **SYNCHRONISEUR À FRÉQUENCE AJUSTÉE POUR CROISEMENT DE DOMAINES D'HORLOGE**

(57)     Dans un contexte de croisement de domaine d'horloge, un synchroniseur à bascules présente un nombre réduit de bascules (110, 113) mises en série, recevant en entrée des données (A_q) d'un premier domaine d'horloge (107) et fournissant en sortie (120) des données dans le deuxième domaine d'horloge (114). Le deuxième signal d'horloge est à fréquence variable ajustée à une fréquence cible, par un facteur de division (k0). Les bascules (110, 113) sont cadencées par un signal d'horloge (CLK_k) sous-échantillonnant le deuxième signal d'horloge (CLK_B) par un facteur k1. Le signal d'horloge sous-échantillonné est généré par un diviseur de fréquence (301) propageant une impulsion du signal (CLK_B) toutes les k1 impulsions d'horloge, en gardant les fronts alignés. Des bascules théoriquement supplémentaires (111, 112) sont évitées.

FIG.6

**Description**

DOMAINE TECHNIQUE

Des modes de réalisation et de mise en œuvre concernent le domaine de la synchronisation de données dans des systèmes ayant des domaines d'horloge asynchrones.

CONTEXTE TECHNIQUE

Un système numérique est souvent composé de plusieurs sous-systèmes numériques. Lorsque ces sous-systèmes numériques fonctionnent de manière synchrone avec la même horloge, la synchronisation des signaux circulant entre ces sous-systèmes numériques n'est pas nécessaire. En revanche, si ces sous-systèmes numériques sont asynchrones, i.e., fonctionnent avec des horloges asynchrones au moins en phase, les signaux circulant entre ces sous-systèmes numériques doivent être synchronisés. Par exemple, un système informatique peut fonctionner à une fréquence donnée, alors que le processeur peut fonctionner à une autre fréquence.

Un circuit d'interface qui permet le transfert de données d'un domaine d'horloge à un autre est appelé unité de synchronisation ou « synchroniseur ».

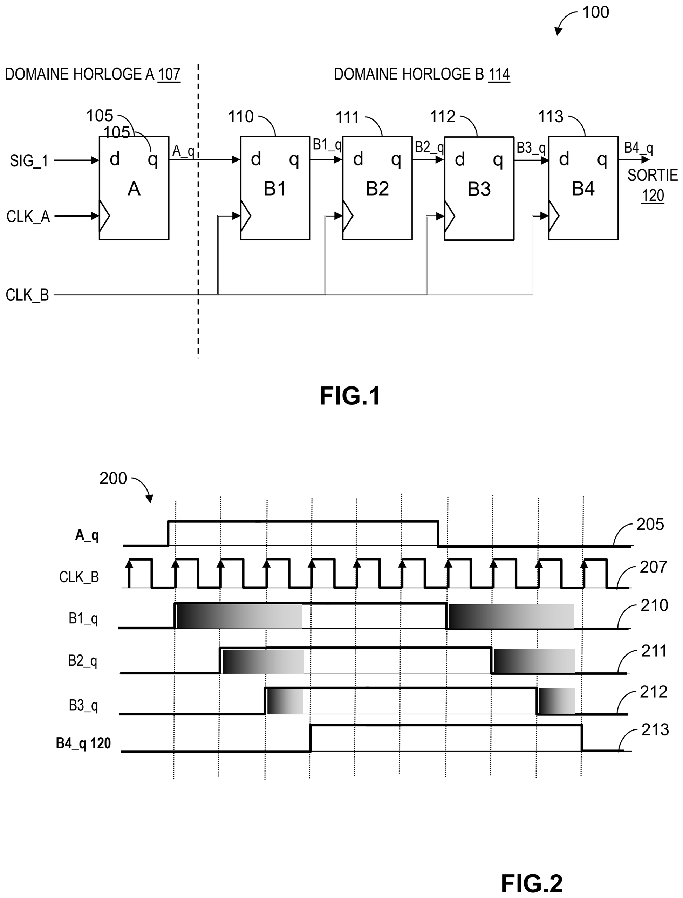

La **FIG.1** illustre un synchroniseur à bascules 100 selon l'état de l'art pour synchroniser un signal de données SIG_1. La bascule (« flip-flop » en langue anglo-saxonne) A 105 fonctionne dans le domaine d'horloge d'origine A 107. Le jeu de bascules B fonctionnent dans le domaine d'horloge cible B 114.

De façon connue, une bascule est un circuit logique mettant en œuvre un opérateur entre ses entrées et maintenant les valeurs de sa ou ses sorties - évaluées à un front d'horloge - pendant la durée du cycle d'horloge.

Le domaine d'horloge A 107 et le domaine d'horloge B 114 sont des domaines d'horloge asynchrones. La bascule A 105 reçoit le signal d'entrée SIG_1 à l'entrée de données « d » et est cadencée à une première fréquence d'horloge $f_A$, par le premier signal d'horloge CLK_A à l'entrée d'horloge. La FIG.1 illustre un jeu de quatre bascules B1 110, B2 111, B3 112 et B4 113 fonctionnant en série ou « cascade » (la sortie « q » de la bascule précédente alimentant l'entrée « d » de la suivante). Un autre nombre de bascules peut être envisagé. Notamment, des synchroniseurs à deux bascules B sont largement connus.

Le signal d'entrée SIG_1 est transféré à la sortie « q » de la bascule A 105 par l'action du premier signal d'horloge CLK_A. Les bascules du jeu B sont cadencées à une deuxième fréquence d'horloge $f_B$, par le deuxième signal d'horloge CLK_B, et le signal de sortie à la sortie « q » de la bascule A 105 est transféré en série via chacune des bascules du jeu B jusqu'à la sortie « q » finale au niveau du nœud de sortie 120.

Si une source d'horloge (par exemple $f_B$) présente une fréquence d'opération maximale ($f_{Bmax}$), elle peut cependant être de fréquence variable dans le cas où un utilisateur peut ajuster la fréquence du domaine au travers d'un diviseur d'horloge intégré à la source d'horloge.

La **FIG.2** illustre un diagramme temporel 200 des signaux du synchroniseur 100. Sont représentés, le signal A_q 205 en sortie de bascule A 105 - c'est-à-dire en entrée du domaine d'horloge cible B 114 -, le signal d'horloge CLK_B 207 du domaine d'horloge cible B 114, le signal B1_q 210 en sortie de la première bascule B1 110, le signal B2_q 211 en sortie de la bascule suivante B2 111, le signal B3_q 212 en sortie de la bascule encore suivante B3 112 et le signal B4_q 213 en sortie de la dernière bascule B4 114. Le signal B4_q correspond ici au signal de sortie SORTIE 120. Chaque signal Bi_q de sortie d'une bascule intermédiaire Bi correspond au signal B(i+1)_d d'entrée de la bascule intermédiaire suivante B(i+1).

Il existe une probabilité que lors de l'échantillonnage du signal A_q par la bascule B1 110 dans le domaine d'horloge cible 114, la sortie B1_q de la bascule B1 puisse passer dans un état métastable. Cette probabilité - qui décroit dans le temps - est illustrée symboliquement par le dégradé après chaque front. La bascule suivante B2 aura une probabilité plus faible de faire de même (illustrée symboliquement par le dégradé), et ainsi de suite.

Ces risques d'état métastable sont fonction des paramètres des bascules et de la fréquence cible $f_B$ de l'horloge CLK_B. La mise en série des quatre bascules permet de réduire ce risque d'état métastable en sortie 120, au prix d'un échantillonnage décalé d'un nombre de cycles d'horloge correspondant au nombre de bascules additionnelles (par exemple par rapport à un synchroniseur à deux bascules). Le nombre $N_{sync}$ de bascules B à utiliser est généralement déterminé par la formule suivante :

$$MTBF = \frac{e^{t/t_r}}{N.f_A.f_B.T_w}$$

où t, le temps de résolution, vaut

$$t = (N_{sync} - 1).(\frac{1}{f_B} - T_{setup} - T_{cp \to q} - T_{uncertainty})$$

MTBF est le temps moyen de bon fonctionnement souhaité (« Mean Time Between Failures » en langue anglo-saxonne).

$t_r$ (temps de résolution d'une bascule), Tw (fenêtre de métastabilité), N (nombre total de bascules dans le synchroniseur ou système de synchronisation), $T_{setup}$ (durée de setup d'une bascule), $T_{cp \to q}$ (temps de latence CP - impulsion d'horloge - à Q - sortie - d'une bascule), $T_{uncertainty}$ (constante) sont des paramètres fixés, liés aux bascules et/ou au design de circuit choisi.

Un nombre $N_{sync}$ de bascules plus élevé est préjudiciable à la compacité du synchroniseur 100, de même qu'à sa consommation électrique. Il retarde en outre la conversion du signal d'entrée SIG_1 dans le domaine d'horloge cible.

Pour contenir ce nombre, il y a lieu d'améliorer les performances des bascules, ce qui a un coût.

En outre, la recherche de performances accrues du domaine d'horloge B 114 s'accompagne généralement d'une augmentation de la fréquence $f_B$, et de ce fait d'un nombre toujours plus grand de bascules pour un MBTF maintenu. A titre d'exemple, la fréquence $f_B$ peut aller de quelques dizaines de MHz (par exemple 10 à 50 MHz) à plusieurs centaines de MHz (par exemple 400 MHz).

Il existe donc un besoin d'améliorer les synchroniseurs entre domaines d'horloge asynchrones pour pallier les inconvénients susmentionnés.

RESUME

Il est constaté que les multiples bascules mises en série visent à réduire les risques d'état métastable en allongeant le temps d'échantillonnage d'un nombre de cycles d'horloge correspondant au nombre de bascules additionnelles. Aussi, toutes ou partie des bascules intermédiaires peuvent apparaître superflues dès lors que le temps d'échantillonnage est conservé.

Dans cette perspective, il est proposé une unité de synchronisation entre un premier domaine d'horloge cadencé par un premier signal d'horloge et un deuxième domaine d'horloge asynchrone au premier domaine d'horloge et cadencé par un deuxième signal d'horloge, l'unité de synchronisation comprenant :

un jeu de bascules mises en série, recevant en entrée des données du premier domaine d'horloge et fournissant en sortie des données dans le deuxième domaine d'horloge (i.e., la première bascule recevant l'entrée, la dernière bascule délivrant la sortie),
dans laquelle le deuxième signal d'horloge est à fréquence variable ajustée à une fréquence cible pour alimenter un signal d'horloge cadençant les bascules et/ou les bascules sont cadencées par un signal d'horloge sous-échantillonnant le deuxième signal d'horloge.

Deux mécanismes, éventuellement combinables, permettent d'ajuster la période entre deux fronts montants (ou descendants) au nombre de bascules utilisées. En ajustant, généralement à la baisse, la fréquence d'horloge utilisée par les bascules de l'unité de synchronisation, le nombre de bascules peut être réduit. Aussi, l'unité de synchronisation peut être compacte et économe en consommation électrique.

Une source d'horloge à fréquence variable comprend typiquement un diviseur d'horloge permettant d'ajuster la fréquence en sortie par un facteur entier k0 (de la fréquence opérationnelle maximale). La période d'horloge est donc multipliée par k0. La fréquence du deuxième signal d'horloge peut ainsi être ajustée au nombre de bascules utilisées.

On entend par « sous-échantillonner » tout processus visant à réduire la fréquence du signal d'horloge par un facteur entier 'k1' supérieur à 1. La période d'horloge est donc multipliée par k1. Concrètement, des cycles (ou impulsions) d'horloge sont supprimés du signal d'horloge. Les signaux d'horloge et d'horloge sous-échantillonné demeurent en phase, signifiant que les fronts montants (ou descendants) d'horloge conservés sont alignés avec ceux du signal d'horloge initial (le deuxième signal d'horloge).

Par ailleurs, en fixant le facteur k0 de division et/ou k1 de sous-échantillonnage, il est possible d'obtenir une réduction substantielle du nombre de bascules, typiquement à seulement deux unités.

Il est également possible, par le choix du ou des facteurs k0 et k1, de compenser d'autres paramètres de la formule ci-dessus, typiquement les paramètres des bascules. Aussi, il est à nouveau possible d'utiliser tout type de bascules, incluant celles moins performantes, et donc de ne pas avoir de contrainte à développer de nouveaux types de composant plus performants.

Selon un autre aspect, il est proposé un procédé de synchronisation entre un premier domaine d'horloge cadencé par un premier signal d'horloge et un deuxième domaine d'horloge asynchrone au premier domaine d'horloge et cadencé par un deuxième signal d'horloge, le procédé comprenant les étapes suivantes :

obtenir au moins un facteur de division d'horloge ou de sous-échantillonnage d'horloge,

ajuster, à l'aide du facteur de division d'horloge, une fréquence variable du deuxième signal d'horloge à une fréquence cible pour alimenter un signal d'horloge cadençant les bascules et/ou générer, à l'aide du facteur de sous-échantillonnage d'horloge obtenu, un signal d'horloge sous-échantillonnant le deuxième signal d'horloge, et

piloter, avec le signal d'horloge ajusté et/ou généré, des bascules mises en série dans une unité de synchronisation qui reçoit en entrée des données du premier domaine d'horloge et fournit en sortie des données dans le deuxième domaine d'horloge.

Il est aussi proposé un système électronique comprenant une unité de synchronisation telle que définie dans la présente divulgation.

Des caractéristiques facultatives de modes de réalisation sont définies ci-après en référence au dispositif, tandis qu'elles peuvent être transposées en caractéristiques de procédé.

Dans un mode de réalisation, l'unité de synchronisation comprend un sous-échantillonneur (ou unité de sous-échantillonnage) configuré pour sous-échantillonner un signal en entrée par un facteur de sous-échantillonnage k1, entier supérieur ou égal à 2, le sous-échantillonneur recevant, comme signal d'entrée, le deuxième signal d'horloge.

Dans un mode de réalisation, l'unité de synchronisation comprend une interface utilisateur pour permettre une configuration du facteur de sous-échantillonnage k par un utilisateur. L'utilisateur peut ainsi aisément ajuster ou accorder un design d'unité de synchronisation (comprenant par exemple deux bascules) à une fréquence cible $f_b$ variable et/ou à des bascules de tous types.

Dans un mode de réalisation, une source du deuxième signal d'horloge comprend un diviseur d'horloge configuré pour ajuster le deuxième signal d'horloge par un facteur de division k0, entier supérieur ou égal à 2. Le facteur de division k0 peut par exemple être renseigné par un utilisateur, via une interface dédiée.

Dans un mode de réalisation, le sous-échantillonneur (301, 400) comprend un module d'adaptation du facteur de sous-échantillonnage k1 à un ajustement d'une fréquence $f_B$ du deuxième signal d'horloge par le facteur de division k0. Plus généralement, le module d'adaptation peut ajuster k0 en fonction de toute variation de fréquence du deuxième signal d'horloge, compte tenu du nombre de bascules utilisées. La description ci-dessous indique par exemple comment déterminer k1 en fonction de la fréquence du deuxième signal d'horloge et du nombre de bascules.

Dans un mode de réalisation, le sous-échantillonneur comprend une cellule de déclenchement d'horloge (« clock gating cell » en langue anglo-saxonne) couplée à un compteur d'impulsions dans le signal en entrée. Le compteur compte 'k1' impulsions pour émettre un signal d'activation à la cellule de déclenchement d'horloge de sorte que cette dernière laisse passer le signal en entrée, jusqu'à l'impulsion suivante.

Dans un mode de réalisation, le jeu de bascules comporte deux bascules en série uniquement. Comme décrit par la suite, un plus grand nombre de bascules peut être prévu.

Dans un mode de réalisation, lorsqu'une formule de temps moyen de bon fonctionnement (MTBF) souhaité lie un nombre théorique $N_{sync}$ de bascules à une première fréquence $f_A$ du premier signal d'horloge et une deuxième fréquence $f_B$ (éventuellement ajustée) du deuxième signal d'horloge : $N_{sync}$=fonction($f_A$,$f_B$), un facteur de sous-échantillonnage k1 est fixé à un facteur k2 choisi parmi les facteurs de $N_{sync}$-1. Un facteur de $N_{sync}$-1 est compris au sens de la multiplication : tout entier (incluant 1 et $N_{sync}$-1) qui peut diviser $N_{sync}$-1 (division euclidienne sans reste). Le facteur de sous-échantillonnage k1 est un entier supérieur ou égal à 2.

Dans ce cas, le nombre de bascules en série (dans ledit jeu de bascules) est égal à ($N_{sync}$-1)/k2 + 1, afin de conserver une durée constante d'échantillonnage des données en entrée. Par exemple, si on sous-échantillonne avec un facteur égal à $N_{sync}$-1, alors seulement deux bascules sont nécessaires en série. Si $N_{sync}$-1 est pair et que l'on sous-échantillonne avec un facteur égal à ($N_{sync}$-1)/2, alors trois bascules sont utilisées en série. Et ainsi de suite.

Il est également proposé un système de synchronisation comprenant :

une première unité de synchronisation comme ci-dessus entre un premier domaine d'horloge cadencé par un premier signal d'horloge et un deuxième domaine d'horloge asynchrone au premier domaine d'horloge et cadencé par un deuxième signal d'horloge,

une deuxième unité de synchronisation comme ci-dessus entre un troisième domaine d'horloge cadencé par un troisième signal d'horloge distinct du premier signal d'horloge et le deuxième domaine d'horloge asynchrone au troisième domaine d'horloge,

dans lequel un sous-échantillonneur partagé fournit le même signal d'horloge sous-échantillonnant le deuxième signal d'horloge, aux bascules des première et deuxième unités de synchronisation.

Bien entendu, le sous-échantillonneur peut cadencer les bascules d'un plus grand nombre d'unités de synchronisation entre diverses domaines d'horloge d'origine et le même deuxième domaine d'horloge cible asynchrone à ces domaines d'horloge d'origine.

Si la réduction du nombre de bascules dans un synchronisateur devrait permettre de compenser l'ajout du sous-échantillonneur, la mutualisation de ce dernier à plusieurs domaines d'horloge d'origine garantit un bénéfice réel en termes de surface silicium occupée et de consommation électrique rapportées à chaque synchroniseur.

BREVE DESCRIPTION DES FIGURES

D'autres avantages et caractéristiques de l'invention apparaîtront à l'examen de la description détaillée de mode de réalisation et de mise en œuvre, nullement limitatifs, et des dessins annexés sur lesquels :

[Fig. 1] ; et
[Fig. 2] illustrent des techniques connues ;
[Fig. 3] ;
[Fig. 4];
[Fig. 5] ;
[Fig. 5A] ;
[Fig. 5B] ;

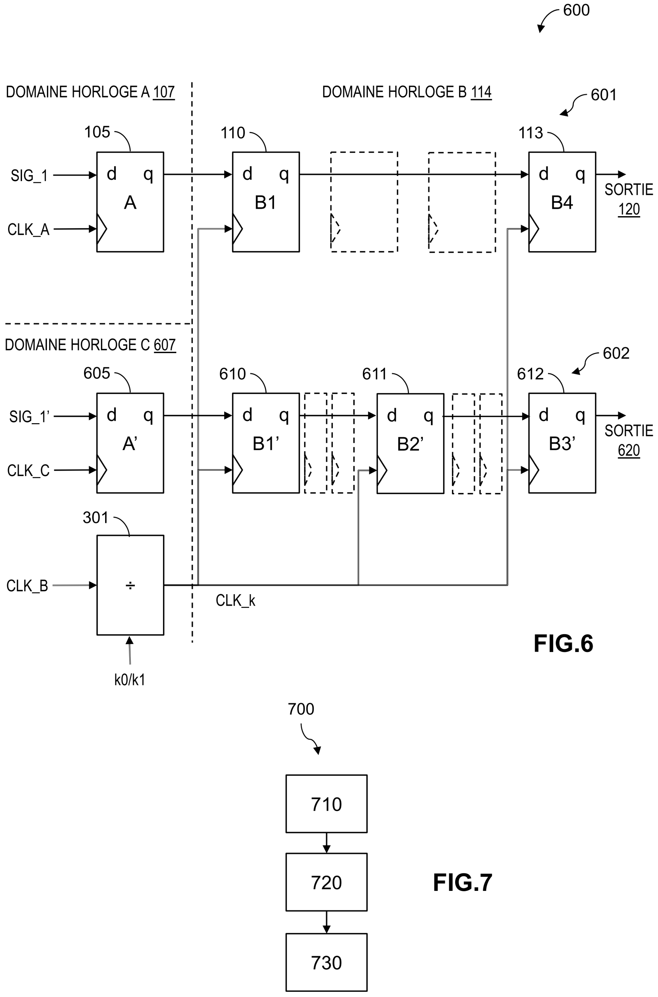

[Fig. 6] ; et
[Fig. 7] illustrent schématiquement des modes de mise en œuvre et de réalisation de l'invention.

DESCRIPTION DETAILLEE

Dans un contexte de croisement de domaine d'horloge, un synchroniseur à bascules présente un nombre réduit de bascules mises en série, recevant en entrée des données d'un premier domaine d'horloge et fournissant en sortie des données dans le deuxième domaine d'horloge. Le deuxième signal d'horloge est à fréquence variable ajustée à une fréquence cible, par un facteur de division k0. Les bascules sont cadencées par un signal d'horloge sous-échantillonnant le deuxième signal d'horloge par un facteur k1. Le signal d'horloge sous-échantillonné est généré par un diviseur de fréquence propageant une impulsion du signal toutes les k1 impulsions d'horloge, en gardant les fronts alignés. Des bascules théoriquement supplémentaires sont évitées.

Les systèmes électroniques tels que les systèmes automobiles peuvent être mis en œuvre sous la forme d'un système sur puce (SoC pour « System on Chip » en langue anglo-saxonne) qui est un circuit intégré comprenant tous les composants du système, comprenant souvent, par exemple, des composants associés à des domaines d'horloge différents et asynchrones.

Un croisement de domaine d'horloge (« clock domain crossing » en langue anglo-saxonne) se produit lorsque des données sont transférées d'une bascule (une bascule « source ») pilotée ou cadencée par une première horloge CLOCK_A vers une bascule (une bascule « de destination » ou « cible ») pilotée par une seconde horloge CLOCK_B.

Selon la relation entre les horloges, des problèmes peuvent survenir lors du transfert de données entre la bascule source et la bascule cible. À titre d'exemple, si une transition à la sortie de la bascule source se produit très près du front actif (montant ou descendant) de la deuxième horloge, une violation de configuration ou de maintien au niveau de la bascule cible peut se produire. Cela peut entraîner une oscillation de la sortie de la deuxième bascule, qui peut devenir instable et ne pas se stabiliser à une valeur stable avant le prochain front actif de la deuxième horloge. Cette condition est appelée métastabilité.

Pour réduire l'incertitude liée à la métastabilité de la bascule cible, il est classique de mettre en série plusieurs bascules cibles permettant d'allonger le temps d'échantillonnage des données à plusieurs cycles d'horloge, là où les risques de métastabilité sont quasi-nuls.

Le nombre $N_{sync}$ de bascules cibles est généralement obtenu par la formule du temps moyen de bon fonctionnement MTBF déjà mentionnée plus haut.

Ce nombre $N_{sync}$ de bascules nécessaires à la synchronisation des données dans le deuxième domaine d'horloge croit rapidement avec la fréquence $f_B$ du deuxième domaine d'horloge - condition recherchée pour améliorer ses performances -, mais également avec l'utilisation de bascules moins performantes - condition utile pour diminuer les coûts et avoir un design plus simple et moins onéreux avec l'utilisation de bascules standards et identiques.

Un nombre $N_{sync}$ élevé de bascules est préjudiciable à la compacité du synchroniseur 100, de même qu'à sa consommation électrique.

Les systèmes électroniques pouvant comporter un grand nombre d'unités de synchronisation entre domaines d'horloge asynchrones, toute bascule supplémentaire dans ces unités amène au même préjudice en termes de compacité et consommation électrique.

L'ajustement d'une fréquence variable du deuxième signal d'horloge à une fréquence cible pour alimenter un signal d'horloge cadençant les bascules et/ou l'utilisation de bascules pilotées ou cadencées par un signal d'horloge sous-échantillonnant le deuxième signal d'horloge cible CLOCK_B permet de réduire le nombre de bascules tout en conservant un temps constant d'échantillonnage des données en entrée, pour maintenir inchangés le MTBF et donc les risques de métastabilité. Aussi, la création d'une horloge virtuelle générant ce signal d'horloge ajusté et/ou sous-échantillonné permet de surmonter les inconvénients des techniques connues.

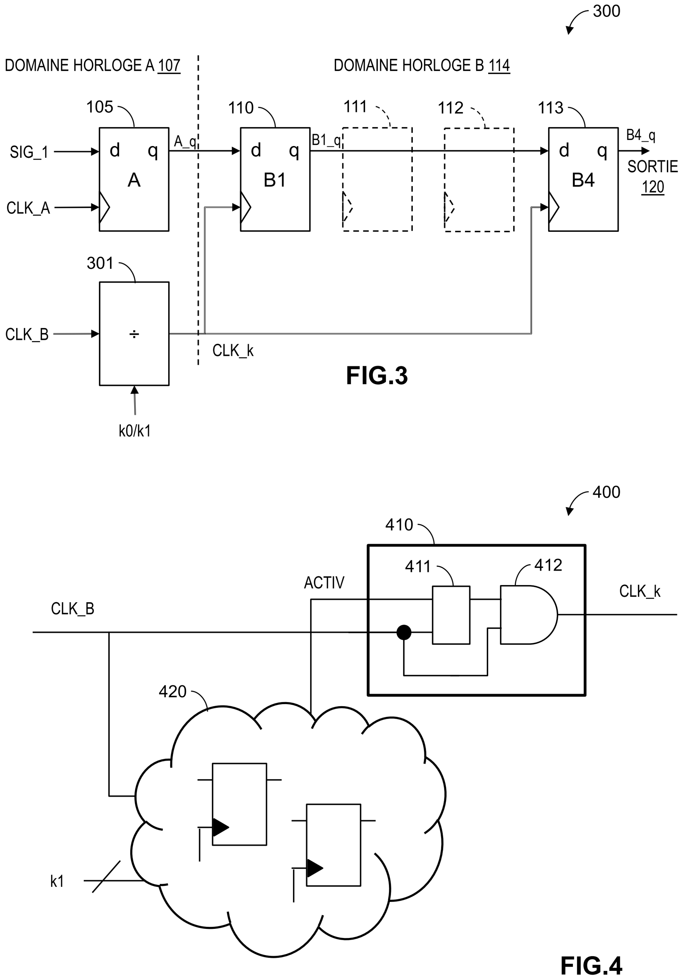

La **FIG.3** illustre une unité de synchronisation selon des modes de réalisation.

A des fins d'illustration uniquement, les deux bascules intermédiaires 111, 112 - désormais superflues - sont représentées en pointillés pour illustrer comment cette unité de synchronisation améliore celle de la FIG.1 discutée plus haut.

Le synchroniseur à bascules 300 de la FIG.3 comprend à nouveau la bascule A 105 dans le domaine d'horloge d'origine A 107 et le jeu de bascules B dans le domaine d'horloge cible B 114.

Les bascules sont typiquement des bascules D (pour Data), i.e., comportant une unique entrée de données : « d », dont la valeur est recopiée sur la sortie « q » à chaque front d'horloge (ici front montant, mais en variante ce peut être au front descendant). La bascule D permet d'assurer un état de sortie stable entre deux fronts d'horloge.

Le jeu de bascules B comporte deux bascules B1 110 et B4 113 en série, cadencées par une horloge CLK_k.

L'horloge CLK_k peut être la deuxième horloge CLK_B ajustée à une fréquence cible, par exemple adaptée au nombre de bascules utilisées. Le signal d'horloge cible CLK_B peut être généré par tout générateur d'horloge connu - et donc non détaillé ici - tel qu'un oscillateur électronique (typiquement un circuit RLC). Il est connu qu'une source d'horloge à fréquence variable est dotée d'un diviseur d'horloge 301 (par un facteur entier d'horloge k0) permettant d'ajuster à la baisse la fréquence d'horloge en sortie de la source, par rapport à une fréquence opérationnelle maximale $f_{Bmax}$.

L'horloge CLK_k peut être une horloge virtuelle CLK_k qui sous-échantillonne l'horloge cible CLK_B, éventuellement préalablement ajustée par un facteur d'horloge k0. L'horloge virtuelle est mise en œuvre à l'aide de l'unité de sous-échantillonnage d'horloge 301 qui reçoit en entrée le signal d'horloge CLK_B (éventuellement ajusté par k0) et le paramètre k1 de sous-échantillonnage, entier supérieur ou égale à 2. Dans l'exemple de la figure, k=3, permettant de diviser par k=3 la fréquence d'horloge (e.g., des fronts montants) entre le signal d'horloge CLK_B (fréquence : $f_B$) et le signal d'horloge sous-échantillonné CLK_k (fréquence : $f_k=f_B/k1$).

Le ou les paramètres k0 et k1 peuvent être préfixés dans un registre ou une mémoire du synchroniseur 300. En variante, ils peuvent être ajustés par un utilisateur au travers d'une interface utilisateur (non illustrée). En variante encore, ils peuvent être dynamiquement adaptés (par un module d'adaptation non représenté sur la FIG.4 ci-dessous) : par exemple, le facteur de sous-échantillonnage k1 peut être ajusté aux variations de la fréquence $f_B$ du domaine d'horloge cible B par le facteur de division k0 (e.g. lorsque l'utilisateur modifie k0).

La **FIG.4** illustre une réalisation d'une unité de sous-échantillonnage 400. Toute autre réalisation connue de l'homme de l'art peut être utilisée.

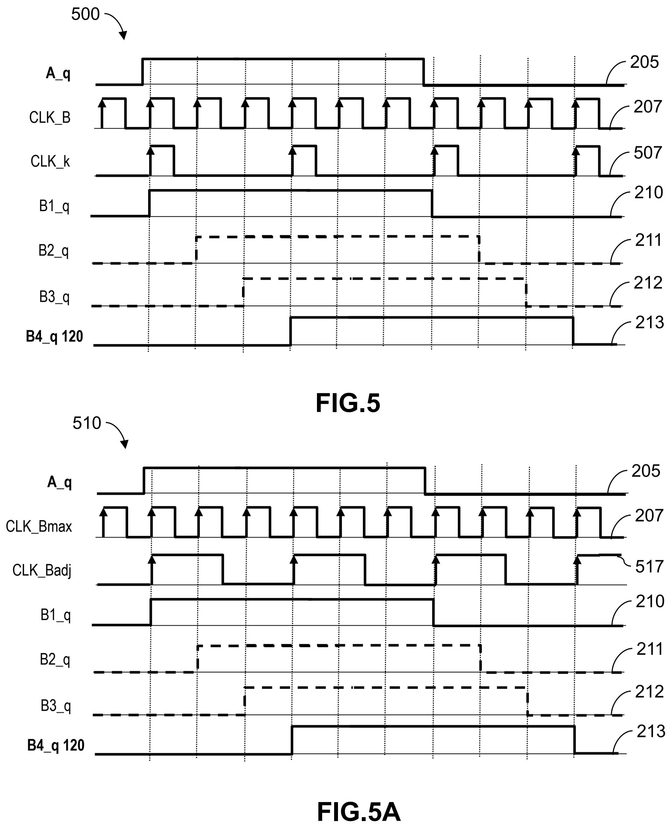

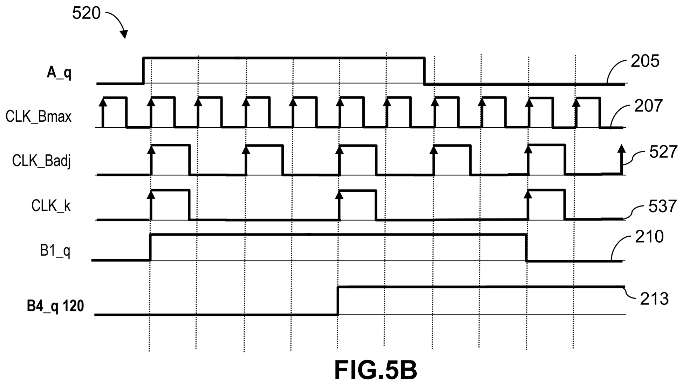

L'unité de sous-échantillonnage permet de générer le signal d'horloge sous-échantillonné CLK_k en supprimant certaines impulsions du signal d'horloge CLK_B (ou en recopiant les autres impulsions dans un nouveau signal). Ainsi, les signaux CLK_k et CLK_B demeurent en phase (leurs fronts d'impulsions sont alignés, pour les impulsions communes), comme cela est illustré en FIG.5.

L'unité de sous-échantillonnage 400 représentée comprend une cellule de déclenchement d'horloge 410 (« clock gating cell » en langue anglo-saxonne) couplée à un compteur d'impulsions 420 dans le signal en entrée, ici CLK_B.

Le compteur d'impulsions 420 est représenté ici de façon très schématique car il en existe de nombreuses réalisations possibles, accessibles à l'homme de l'art. Le compteur d'impulsions 420 est configuré pour compter les impulsions du signal en entrée CLK_B, typiquement à chaque front montant (ou en variante descendant) et, en fonction du paramètre k1, pour générer un état « haut » ou « fort » d'un signal d'activation ACTIV à destination de la cellule de déclenchement d'horloge 410 à chaque fois que k1 impulsions ont été comptées dans le signal en entrée CLK_B.

La cellule de déclenchement d'horloge 410 arrête essentiellement la propagation du signal d'horloge CLK_B à travers elle lorsqu'un signal d'activation ACTIV à un niveau « bas » ou « faible » lui est appliqué. Seules les impulsions du signal d'horloge CLK_B lors d'un signal d'activation ACTIV haut sont propagées vers CLK_k.

Par exemple, lorsque k1=3, seule une impulsion sur trois est propagée vers la sortie CLK_k.

La cellule de déclenchement d'horloge 410 est de type verrou-ET, comportant un verrou (ou « latch » en langue anglo-saxonne) 411 et une porte ET 412. Le verrou 411 est commandé par le signal d'activation ACTIV pour activer la porte ET 412 pendant une période d'horloge, chaque k1 périodes. La porte ET 412 laisse donc se propager le signal d'horloge CLK_B pendant une période d'horloge chaque k périodes, laissant donc passer une impulsion sur k1.

La **FIG.5** illustre un diagramme temporel 500 des signaux du synchroniseur 301 ou 400, avec kl=3. Les signaux B2_q et B3_q de la FIG.1 sont laissés apparents (en pointillés) à toutes fins utiles alors même qu'ils n'existent plus au sein du synchroniseur.

L'unité de sous-échantillonnage 400 laissant se propager une impulsion sur trois du signal CLK_B, la signal d'horloge sous-échantillonné est constitué d'une impulsion d'horloge chaque trois cycles d'horloge B, donc à une fréquence $f_B/3$. Les impulsions du signal CLK_k 507 sont parfaitement alignées en phase (en fronts) avec celles du signal CLK_B 207 initial.

Puisque les bascules B sont pilotées par le signal CLK_k, la première bascule B1 prend la valeur de la donnée A_q à une impulsion du signal CLK_k, et la deuxième bascule B4 en série prend la valeur de la donnée B1_q à l'impulsion suivante du signal CLK_k. La deuxième bascule B4 n'opère donc pas au cycle d'horloge B suivant celui de la première bascule B1, mais à un cycle de l'horloge virtuelle suivant, donc après k1=3 cycles d'horloge B. Cela garantit de conserver le temps d'échantillonnage inchangé : la bascule B4 de l'unité de synchronisation 400 opère aux mêmes instants que la bascule B4 de l'unité de synchronisation 100 (FIG.2).

Bien que l'exemple de la FIG.3 illustre deux bascules B, l'unité de synchronisation 400 peut en contenir un plus grand nombre, lequel est réduit par rapport au nombre théorique $N_{sync}$ de bascules pour la fréquence $f_B$ cible.

De même, bien que l'exemple ci-dessus de la FIG.3 soit décrit avec un facteur de sous-échantillonnage égal à 3, d'autres valeurs peuvent être utilisées.

La formule de temps moyen de bon fonctionnement (MTBF) ci-dessus lie le nombre théorique $N_{sync}$ de bascules à la fréquence $f_A$, la fréquence $f_B$, mais également au MTBF souhaité et aux caractéristiques des bascules utilisées. Ce nombre $N_{sync}$ peut être 3, 4, 5, 6, voire plus. Si les techniques connues imposent des réalisations matérielles prévoyant ce nombre exact (ou plus) de bascules, l'approche décrite ci-dessus permet d'en réduire le nombre.

Elle permet notamment d'utiliser des bascules moins performantes (par exemple des bascules classiques) sans augmenter (voire en réduisant) le nombre de bascules réellement utilisées. L'approche décrite ci-dessus offre donc un accès élargi au catalogue des bascules disponibles sans impact sur la performance de l'unité de synchronisation.

Elle permet aussi d'améliorer les performances du domaine d'horloge cible B - via l'augmentation de sa fréquence $f_B$ opérationnelle - sans augmenter (voire en réduisant) le nombre de bascules réellement utilisées.

Typiquement, le nombre $N_{sync}$-1 obtenu selon les contraintes en jeu (MTBF souhaité, $f_A$, $f_B$, caractéristiques des bascules utilisées) présente deux ou plus facteurs, au sens de la multiplication, à savoir au moins 1 et $N_{sync}$-1, et éventuellement tout diviseur entier de $N_{sync}$-1. Tout facteur k2 parmi ces deux ou plus facteurs peut être choisi comme facteur de sous-échantillonnage k1.

Par exemple, pour $N_{sync}$=5, les facteurs suivants sont disponibles : 1, 2, 4 ; pour $N_{sync}$=6 : 1 et 5 ; pour $N_{sync}$=7 : 1, 2, 3, 6 ; etc.

Le choix du facteur k2 peut être fonction du nombre de bascules à mettre en œuvre, et ou des possibilités offertes par l'unité de sous-échantillonnage 301, 400.

Le nombre $N_B$ de bascules B est en effet lié au facteur k2 choisi par la formule suivante, pour conserver un temps constant d'échantillonnage de la donnée en entrée : $N_B = (N_{sync}-1)/k2 + 1$.

Ainsi, si k2 = $N_{sync}$-1, alors seulement deux bascules B sont nécessaires au lieu de $N_{sync}$. C'est le cas de la FIG.3 où l'on passe de quatre ($N_{sync}$=4) bascules B (voir FIG.1) à seulement deux en divisant la fréquence de pilotage des bascules par 3 ($N_{sync}$-1).

A titre illustratif, si $N_{sync}$=5 et k2=2, alors trois bascules B peuvent être utilisées au lieu de cinq ; si $N_{sync}$=7 et k2=2, alors quatre bascules B sont nécessaires alors qu'avec k2=3, trois bascules B peuvent être utilisées au lieu de sept.

Bien qu'il soit envisagé ci-dessus de rester à iso-temps d'échantillonnage de la donnée en entrée, il est cependant possible d'utiliser les enseignements ci-dessus pour réduire le nombre de bascules, même en allongeant le temps d'échantillonnage de la donnée en entrée.

Par exemple, si une unité de sous-échantillonnage 301, 400 est déjà disponible avec un facteur k1 de sous-échantillonnage non compatible avec le nombre théorique $N_{sync}$ de bascules B (k1 ne divise pas $N_{sync}$-1), alors on peut utiliser un $N_{sync}$' théorique plus élevé qui satisfasse la condition : k1 divise $N_{sync}$'-1. L'allongement du temps d'échantillonnage est alors égal à $(N_{sync}'-N_{sync})/f_B$.

A titre illustratif, si $N_{sync}$=5 et que l'unité de sous-échantillonnage divise $f_B$ par 3, alors $N_{sync}$' peut être fixé à 7. Trois bascules B seront alors utilisées au lieu des 5 ($N_{sync}$). En revanche, le temps d'échantillonnage passera de $5/f_B$ à $7/f_B$.

Enfin, il existe des scénarios où la fréquence $f_B$ est ajustée (e.g., par un utilisateur) d'un facteur de division k0 pour ralentir (ou accélérer) l'horloge dans le temps, alors que l'unité de synchronisation 301, 400 est en opération (donc le nombre de bascules B est fixé comme ci-dessus). Dans ce cas, l'unité de sous-échantillonnage 301, 400 peut être dotée d'un module d'adaptation dynamique (donc automatique) du facteur de sous-échantillonnage k1 aux variations de $f_B$ par le facteur de division k0.

Comme indiqué plus haut, l'unité 301 de la FIG.3 symbolise un diviseur d'horloge lorsque la fréquence $f_B$ de la deuxième horloge CLK_B est ajustée à une fréquence cible par le facteur de division k0, mais également une unité de sous-échantillonnage de l'horloge cible CLK_B par le facteur d'horloge k0. Lorsque les deux opérations (ajustement et sous-échantillonnage) sont mises en œuvre de façon combinée, un diviseur d'horloge est fourni au sein de la source d'horloge CLK_B et un sous-échantillonneur distinct est fourni en avant du signal CLK_B.

Aussi, dans des modes de réalisation, l'unité de sous-échantillonnage 400 de la FIG.4 peut être remplacée (ou complétée) par un diviseur d'horloge connu de l'homme de l'art.

La **FIG.5A** illustre un diagramme temporel 510 des signaux du synchroniseur 301 ou 400, avec k0=3, sans sous-échantillonnage de CLK_B. Les signaux B2_q et B3_q de la FIG.1 sont laissés apparents (en pointillés) à toutes fins utiles alors même qu'ils n'existent plus au sein du synchroniseur.

L'ajustement de la fréquence $f_B$ de l'horloge CLK_B par k0=3 permet de multiplier par k0 la période d'horloge. Les impulsions du signal CLK_Badj 517 sont parfaitement alignées en phase (en fronts) avec celles du signal CLK_Bmax 207 correspondant à la fréquence d'horloge maximale du domaine B, $f_{Bmax}$.

Puisque les bascules B sont pilotées par le signal ajusté CLK_Badj, la première bascule B1 prend la valeur de la donnée A_q à une impulsion du signal CLK_Badj, et la deuxième bascule B4 en série prend la valeur de la donnée B1_q à l'impulsion suivante du signal CLK_Badj, c'est-à-dire à l'issue d'une période correspondant à trois périodes de la fréquence maximale $f_{Bmax}$ de CLK_Bmax.

L'homme du métier comprend ainsi qu'il est possible de combiner les mécanismes d'ajustement de la fréquence $f_B$ du signal d'horloge CLK_B par k0 et de sous-échantillonnage du signal d'horloge CLK_B par k1 afin d'obtenir une période T entre deux fronts de CLK_k ajustée au mieux : $T = (k0.k1)/f_{Bmax}$.

La **FIG.5B** illustre par exemple un diagramme temporel 520 du signal CLK_k, avec k0=2 et k1=2. Le signal ajusté CLK_Badj 527 présente un front montant tous les k0=2 fronts montants du signal CLK_Bmax. Le signal CLK_k 537 présente ainsi un front montant tous les k0.k1=4 fronts montants du signal CLK_Bmax.

Typiquement, k0 et k1 peuvent être choisis tels que k0.k1 est un facteur de $(N_{sync}-1)/(N_B-1)$, $N_{sync}$ étant déterminé en utilisant la fréquence maximale $f_{Bmax}$.

En variante, si un utilisateur fixe k0, la fréquence $f_B$ ajustée est $f_{Bmax}/k0$. k1 peut alors être choisis tels que k1 est un facteur de $(N_{sync}-1)/(N_B-1)$, $N_{sync}$ étant déterminé en utilisant la fréquence ajustée $f_B$.

La **FIG.6** illustre un système de synchronisation 600 basé sur des synchroniseurs à bascule. Ce système de synchronisation peut faire partie d'un système électronique plus complexe dans lequel cohabitent trois ou plus domaines d'horloge. Pour simplifier les explications, il est fait référence à trois domaines d'horloge uniquement qui sont asynchrones : A 107, B 114 et C 607. Bien entendu, un autre nombre de domaines d'horloge peut être mis en œuvre qui reprend les enseignements de la présente divulgation.

Des données des domaines d'horloge A 107 et C 607 sont transmises au domaine d'horloge B asynchrone à A et C, nécessitant des croisements de domaine d'horloge respectifs : A vers B et C vers B.

Si l'unité de synchronisation 601 entre les domaines A et B est, pour l'exemple, identique à celui de la FIG.3, celle 602 entre les domaines C et B comporte trois bascules B en série recevant les données de la bascule A' 605 du domaine C et fournissant la sortie SORTIE 620 : B1' 610, B2' 611 et B3' 612. Il ne s'agit cependant que d'un exemple ; le nombre de bascules B dans l'unité de synchronisation 602 pouvant être le même que celui dans l'unité de synchronisation 601, ou pouvant être supérieur.

Les bascules en pointillées dans l'unité de synchronisation 602 ne sont pas utilisées. Elles illustrent, à toutes fins utiles, les bascules théoriquement nécessaires lorsque $N_{sync}$=7 pour le croisement de domaine d'horloge C vers B.

Les bascules de l'unité de synchronisation 602 peuvent être identiques (de même nature) à celles de l'unité de synchronisation 601, ou être différentes.

Les bascules de l'unité de synchronisation 601 et celles de l'unité de synchronisation 602 sont toutes pilotées par le même signal sous-échantillonné CLK_k issu de l'unité de sous-échantillonnage d'horloge 301. Cette dernière est donc partagée entre plusieurs croisements de domaine d'horloge vers un même domaine d'horloge cible (ici B), donc partagée entre plusieurs domaines d'horloge source (ici A et C).

Les coûts (surface de circuit intégré, consommation électrique) de l'unité de sous-échantillonnage 301 sont ainsi d'autant plus réduits par unité de synchronisation, qu'il y a de nombreux croisements de domaine d'horloge à réaliser vers le même domaine d'horloge.

La **FIG.7** illustre, à l'aide d'un ordinogramme, des opérations 700 dans un système électronique présentant au moins un croisement de domaine d'horloge, c'est-à-dire un système électronique avec plusieurs domaines d'horloge asynchrones qui échangent des données.

Les opérations 700 commencent à l'étape 710 par la récupération du facteur k de sous-échantillonnage d'horloge.

Dans un mode de réalisation, k0 et/ou k1 sont stockés en mémoire ou dans un registre interne au système électronique.

Dans un autre mode de réalisation, k0 et/ou k1 sont saisis par un utilisateur au lancement du système électronique.

Dans encore un autre mode de réalisation, k0 et/ou k1 sont déterminé par le système électronique à partir d'une configuration d'unité de synchronisation 300, 601, 602. Typiquement, d'un côté, des premières informations telles que les fréquences $f_A$, $f_B$, $f_C$ (pour le domaine C), le temps moyen de bon fonctionnement MTBF et les caractéristiques des bascules B utilisées sont connues et de l'autre côté, des deuxièmes informations telles que le nombre $N_B$ de bascules B disponibles dans l'unité de synchronisation 300, 601, 602 (par exemple 2) sont connues. Le système électronique peut donc déterminer le ou les facteurs de division k0 et de sous-échantillonnage d'horloge k1, en calculant tout d'abord $N_{sync}$ avec les premières informations puis en déterminant $k2 = (N_{sync}-1)/(N_B-1)$. Si k2 est un entier, k0=k2 ou k1=k2 ou k0.k1=k2. Sinon un entier supérieur peut être choisi pour k0 et/ou k1, de préférence l'entier immédiatement supérieur : k0 ou k1 ou k0.k1=partie entière supérieure(k2).

A l'étape 720, le diviseur d'horloge ou l'unité de sous-échantillonnage d'horloge 301, 400 est démarrée avec le facteur d'horloge k0 ou de sous-échantillonnage d'horloge k1 respectivement, tel que déterminé à l'étape 710.

Par exemple, en cas de sous-échantillonnage, l'unité de sous-échantillonnage 301, 400 propage une impulsion d'horloge du signal CLK_B sur k1 impulsions. Cela forme le signal d'horloge sous-échantillonné CLK_k. Ainsi, un signal d'horloge CLK_k sous-échantillonnant le signal d'horloge CLK_B est généré.

A l'étape 730, le signal d'horloge sous-échantillonné CLK_k est fourni aux bascules B de l'unité de synchronisation 300, 601, 602 afin de les piloter à une fréquence $f_B/k1$.

Ce pilotage permet de transférer les données du ou des domaines d'horloge sources au domaine d'horloge cible B, de façon synchronisée, en maintenant un temps moyen de bon fonctionnement souhaité.

Bien entendu, la présente divulgation ne se limite pas aux formes de réalisation décrites ci-avant à titre d'exemples ; elle s'étend à d'autres variantes. D'autres réalisations sont possibles.

**Revendications**

1. Unité de synchronisation (300, 601, 602) entre un premier domaine d'horloge (107, 607) cadencé par un premier signal d'horloge (CLK_A, CLK_C) et un deuxième domaine d'horloge (114) asynchrone au premier domaine d'horloge et cadencé par un deuxième signal d'horloge (CLK_B), l'unité de synchronisation comprenant :

   un jeu de bascules (110, 113, 610, 611, 612) mises en série comprenant une première bascule reliée au premier domaine d'horloge et recevant en entrée des données (A_q) du premier domaine d'horloge et comprenant une dernière bascule fournissant en sortie (120, 620) des données dans le deuxième domaine d'horloge,
   dans laquelle le deuxième signal d'horloge (CLK_B) est à fréquence variable ajustée à une fréquence cible ($f_B$) pour alimenter un signal d'horloge cadençant les bascules (110, 113, 610, 611, 612) et/ou les bascules (110, 113, 610, 611, 612) sont cadencées par un signal d'horloge (CLK_k) sous-échantillonnant le deuxième signal d'horloge (CLK_B).

2. Unité de synchronisation (300, 601, 602) selon la revendication 1, comprenant un sous-échantillonneur (301, 400) configuré pour sous-échantillonner un signal en entrée par un facteur de sous-échantillonnage (k1), entier supérieur ou égal à 2, le sous-échantillonneur recevant, comme signal d'entrée, le deuxième signal d'horloge (CLK_B).

3. Unité de synchronisation (300, 601, 602) selon la revendication 1 ou 2, dans laquelle une source du deuxième signal d'horloge comprend un diviseur d'horloge (301, 400) configuré pour ajuster le deuxième signal d'horloge par un facteur de division (k0), entier supérieur ou égal à 2.

4. Unité de synchronisation (300, 601, 602) selon les revendications 2 et 3, dans laquelle le sous-échantillonneur (301, 400) comprend un module d'adaptation du facteur de sous-échantillonnage (k1) à un ajustement d'une fréquence ($f_B$) du deuxième signal d'horloge (CLK_B) par le facteur de division (k0).

5. Unité de synchronisation (300, 601, 602) selon la revendication 2 ou 4, dans laquelle le sous-échantillonneur (301, 400) comprend une cellule de déclenchement d'horloge (410) couplée à un compteur (420) d'impulsions dans le signal en entrée.

6. Unité de synchronisation (300, 601, 602) selon l'une des revendications précédentes, dans laquelle le jeu de bascules comporte deux bascules en série uniquement (110, 113).

7. Unité de synchronisation (300, 601, 602) selon l'une des revendications précédentes, dans laquelle lorsqu'une formule de temps moyen de bon fonctionnement (MTBF) souhaité lie un nombre théorique $N_{sync}$ de bascules à une première fréquence ($f_A$) du premier signal d'horloge (CLK_A) et une deuxième fréquence ($f_B$) du deuxième signal d'horloge (CLK_B), un facteur de sous-échantillonnage k est fixé à un facteur k2 choisi parmi les facteurs de $N_{sync}-1$.

8. Système de synchronisation (600) comprenant :

   une première unité de synchronisation (601) selon l'une des revendications précédentes entre un premier domaine d'horloge (107) cadencé par un premier signal d'horloge (CLK_A) et un deuxième domaine d'horloge (114) asynchrone au premier domaine d'horloge et cadencé par un deuxième signal d'horloge (CLK_B),
   une deuxième unité de synchronisation (602) selon l'une des revendications précédentes entre un troisième domaine d'horloge (607) cadencé par un troisième signal d'horloge (CLK_C) distinct du premier signal d'horloge (CLK_A) et le deuxième domaine d'horloge (114) asynchrone au troisième domaine d'horloge (607),

dans lequel un sous-échantillonneur partagé (301, 400) fournit le même signal d'horloge (CLK_k) sous-échantillonnant le deuxième signal d'horloge (CLK_B), aux bascules (110, 113, 610, 611, 612) des première et deuxième unités de synchronisation (601, 602).

9. Procédé de synchronisation entre un premier domaine d'horloge (107, 607) cadencé par un premier signal d'horloge (CLK_A, CLK_C) et un deuxième domaine d'horloge (114) asynchrone au premier domaine d'horloge et cadencé par un deuxième signal d'horloge (CLK_B), le procédé comprenant les étapes suivantes :

obtenir (710) au moins un facteur de division d'horloge (k0) ou de sous-échantillonnage d'horloge (k1),

ajuster, à l'aide du facteur de division d'horloge, une fréquence variable du deuxième signal d'horloge à une fréquence cible pour alimenter un signal d'horloge cadençant les bascules et/ou générer (720), à l'aide du facteur de sous-échantillonnage d'horloge obtenu, un signal d'horloge (CLK_k) sous-échantillonnant le deuxième signal d'horloge (CLK_B), et

piloter (730), avec le signal d'horloge ajusté et/ou généré (CLK_k), des bascules (110, 113, 610, 611, 612) mises en série dans une unité de synchronisation (300, 601, 602), les bascules comprenant une première bascule reliée au premier domaine d'horloge et qui reçoit en entrée des données (A_q) du premier domaine d'horloge et comprenant une dernière bascule qui fournit en sortie (120, 620) des données dans le deuxième domaine d'horloge.

10. Système électronique comprenant une unité de synchronisation (300, 601, 602) selon l'une des revendications 1 à 7.

DOMAINE HORLOGE A <u>107</u>　　　DOMAINE HORLOGE B <u>114</u>

100

SIG_1 → | d  q | A → | d  q | B1_q | d  q | B2_q | d  q | B3_q | d  q | B4_q
　　　　　　A　　　　B1　　　　　B2　　　　　B3　　　　　B4 → SORTIE <u>120</u>

CLK_A →

CLK_B

105
110　111　112　113

**FIG.1**

200

A_q — 205
CLK_B — 207
B1_q — 210
B2_q — 211
B3_q — 212
B4_q 120 — 213

**FIG.2**

**FIG.3**

**FIG.4**

**FIG.5**

**FIG.5A**

**FIG.5B**

600

DOMAINE HORLOGE A 107

DOMAINE HORLOGE B 114

601

105

110

113

SIG_1 → | d    q |  A  → | d    q |  B1  → ⌐ ¬ → ⌐ ¬ → | d    q |  B4  → SORTIE 120

CLK_A →

DOMAINE HORLOGE C 607

602

605

610

611

612

SIG_1' → | d    q |  A'  → | d    q |  B1'  → | d    q |  B2'  → | d    q |  B3'  → SORTIE 620

CLK_C →

301

CLK_B → | ÷ |

CLK_k

↑
k0/k1

**FIG.6**

700

710

720

730

**FIG.7**

15

**RAPPORT DE RECHERCHE EUROPEENNE**

Europäisches Patentamt
European Patent Office
Office européen des brevets

Numéro de la demande

EP 25 21 0122

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2012/033772 A1 (AGGARWAL MANISH [IN] ET AL) 9 février 2012 (2012-02-09) | 1-7,9,10 | INV. G06F1/12 H03K5/04 |
| A | * alinéas [0003] - [0005] * * alinéas [0017] - [0018] * * alinéas [0022] - [0028] * * figures 1-8 * ----- | 8 | |
| A | US 2003/002606 A1 (CHEN WENLIANG [US] ET AL) 2 janvier 2003 (2003-01-02) * revendications 1-4 * * figures 1-8 * ----- | 1-10 | |

DOMAINES TECHNIQUES RECHERCHES (IPC)

G06F
H03K

Le présent rapport a été établi pour toutes les revendications

| Lieu de la recherche | Date d'achèvement de la recherche | Examinateur |
|---|---|---|
| Berlin | 24 mars 2026 | Maciejewski, Robert |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

**EP 25 21 0122**

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

**24-03-2026**

| Document brevet cité au rapport de recherche | Date de publication | Membre(s) de la famille de brevet(s) | Date de publication |
|---|---|---|---|
| US 2012033772 A1 | 09-02-2012 | AUCUN | |
| US 2003002606 A1 | 02-01-2003 | AUCUN | |

EPO FORM P0460

Pour tout renseignement concernant cette annexe : voir Journal Officiel de l'Office européen des brevets, No.12/82